# EUROPEAN PATENT SPECIFICATION

(11) **EP 0 323 226 B1**
(45) Date of publication and mention of the grant of the patent: **13.09.1995**
(21) Application number: 88312361.4
(22) Date of filing: 28.12.1988
(51) Int. Cl.: G03G 15/16, G03G 15/02

(54) **An image forming apparatus**
Bilderzeugungsgerät
Appareil de formation d'images

(30) Priority: 28.12.1987 JP 336485/87; 18.01.1988 JP 6845/88; 20.05.1988 JP 121952/88; 17.06.1988 JP 148078/88; 18.06.1988 JP 149272/88
(43) Date of publication of application: 05.07.1989
(73) Proprietor: CANON KABUSHIKI KAISHA, Tokyo (JP)
(72) Inventor: Nakamura, Shunji, Yokohama-shi Kanagawa-ken (JP); Kisu, Hiroki, Ichikawa-shi Chiba-ken (JP); Tomoyuki, Yohji, Yokohama-shi Kanagawa-ken (JP); Saito, Masanobu, Yokohama-shi Kanagawa-ken (JP); Araya, Junji, Yokohama-shi Kanagawa-ken (JP); Miyamoto, Toshio, Tokyo (JP)
(74) Representative: Beresford, Keith Denis Lewis

(56) References cited:
- DE-A- 3 512 875
- US-A- 4 171 157
- PATENT ABSTRACTS OF JAPAN, vol. 10, no. 215 (P-481)(2271), 26 July 1986 ; & JP-A-61 53 668
- IBM TECHNICAL DISCLOSURE BULLETIN, vol. 1 B, June 1981, pp. 843-846, New York, US ; R.J. GLIEBE et al. : "Switch regulation of high voltage corona supplies"
- PATENT ABSTRACTS OF JAPAN, vol. 5, no. 202 (P-95)(874), 22 December 1981 ; & JP-A-56 123 577
- PATENT ABSTRACTS OF JAPAN, vol. 3, no. 86 (E-125)(1), 24 July 1979 ; & JP-A-54 63 837

## Description

### FIELD OF THE INVENTION AND RELATED ART

The present invention relates to an image forming apparatus using an electrostatic image transfer process such as an electrostatic copying machine or printer, more particularly to such an image forming apparatus provided with a charging electrode for charging an image bearing member.

An image forming apparatus is known wherein a surface of a photosensitive layer of an image bearing member in the form of a rotatable cylinder is electrically charged by a corona charging device; an electrostatic latent image is formed thereon; the electrostatic latent image is developed; and the developed image is transferred by passing a transfer material (a sheet of paper) through a nip formed between the image bearing member and a transfer drum or roller (charging electrode) press-contacted to the image bearing member, wherein a transfer bias is applied to the transfer roller to transfer the transferable developed (toner) image from the image bearing member surface to the transfer material or sheet.

Such an apparatus involves a problem that the transfer roller is significantly contaminated when the image of the original is larger than the size of the transfer material so that the toner is directly transferred from the image bearing member to the transfer roller or when a jam occurs during image forming operation. If the contamination of the roller takes place, the subsequent transfer material is contaminated, or the transfer bias is substantially decreased with the result that the image transfer becomes insufficient.

In order to avoid the problem, a proposal has already been made that the transfer roller is supplied, during non-transfer operation, with a bias voltage having a polarity opposite to that during the image transfer operation, by which the toner is intentionally transferred to the image bearing member, thus cleaning the transfer roller, as disclosed in Japanese Laid-Open Patent Application Publication 63837/1979 and Japanese Laid-Open Patent Application No 123577/1981, for example.

However, the electric field for transferring the toner from the transfer roller to the image bearing member can be insufficient, only by applying the bias voltage having the opposite polarity (the same polarity as the toner) during the non-transfer operation, described above. Therefore, the transfer roller is not sufficiently cleaned. Recently, a printer of an electrophotographic type using a laser beam or LED elements becomes widely used because computers are widely used. In the printer like this, in order to minimize the light emitting period of the light source to increase the service life, it is frequent that the light is projected to such an area as is going to become an image portion (not background portion) after development, and therefore, the latent image is reverse-developed. When the reverse-development type is used, the polarity of the electrically charged image bearing member and the polarity of the bias voltage applied to the transfer roller for the cleaning are the same, unlike the case of regular development, during non-transfer operation (no sheet between the roller and the image bearing member), and therefore, sufficient electrostatic contrast for the cleaning is not provided.

Reference is made to US Patent Specification No. 4171157 which discloses an electrophotographic apparatus capable of selective application of a transfer bias voltage so as to prevent at least partially undesired charge from being deported on a photosensitve charge retentive layer.

Further, reference is made to Japanese Patent Specification No. 61-53668(A) which discloses an electrophotographic device adapted to prevent the difference of density on a copied picture by switching the output of a primary charger, which triboelectrifies the surface of a photosensitive body, between the area where the photosensitive body is brought into contact with a transfer material and the area where the photosensitive body is not brought into contact with it.

Accordingly, it is a principal concern of the present invention to provide an image forming apparatus wherein toner particles deposited on a transfer electrode are transferred to an image bearing member, thus cleaning the charging electrode.

It is another concern of the present invention to provide an image forming apparatus wherein contaminating toner particles are removed from a transfer electrode, whereby good quality image is consistently provided.

According to the invention there is provided an image forming apparatus, comprising: a movable image bearing member; a first potential application means for electrically charging said image bearing member to a first potential; latent image forming means for forming a latent image on the image bearing member; toner image forming means for forming a toner image on said image bearing member by developing the latent image with toner which is electrically charged; transport means for delivering a recording material to an image transfer position; and image transfer means contactable to the rear of a recording material at said transfer position to transfer the toner image from said image bearing member to the recording material; second potential application means for applying a second potential to said transfer means when the recording material is not at the image transfer position; and a control means capable of controlling the first and second potential application means; characterised in that a potential providing means is included for providing a third potential onto a portion of the image bearing member to be opposed to the image transfer means during its non-transfer action, and in that said control means serves to operate said first and second potential application means and said potential providing means such that said second potential application means applies said second potential to said transfer means when the recording material is not at the transfer position, said potential providing means providing said third potential on that portion of said image bearing member which is to be presented to the transfer position during the application of the second potential by said second application means, wherein said third potential is at a different voltage level to that of the first potential and is remote from the first potential in a direction opposite from that of the polarity of the electrical charge of the toner, whereby an electric field for transferring the toner from said transfer means to said image bearing means is formed by said second potential and said third potential.

The invention will now be described by way of example with reference to the preferred embodiments of the present invention shown in the accompanying drawings in which:-

Figure 1 is a sectional view of an image forming apparatus according to an embodiment of the present invention.

Figure 2 is a timing chart illustrating an operation of the apparatus according to the embodiment of the present invention.

Figure 3 is a sectional view of an image forming apparatus according to another embodiment of the present invention.

Figures 4A and 4B are timing charts illustrating operations of the another embodiment of the present invention.

Figures 5A and 5B are circuit diagrams illustrating power source for the image forming apparatus.

Figure 6 is a graph showing a relation between a surface potential of a photosensitive member and a DC voltage applied to the charging member.

Figures 7 and 8 are sectional views of the image forming apparatuses according to the embodiments of the present invention.

Figure 9 is a timing chart showing a warming-up period.

Figures 10A, 10B and 10C are sectional views illustrating a transfer roller.

Figure 11 is a graph showing a relation between an image transfer efficiency and pressure contact force of the transfer roller to a photosensitive member.

Figure 12 is a somewhat schematic view showing a circuit for connection of a power source in the case of positive development.

### DESCRIPTION OF THE PREFERRED EMBODIMENTS

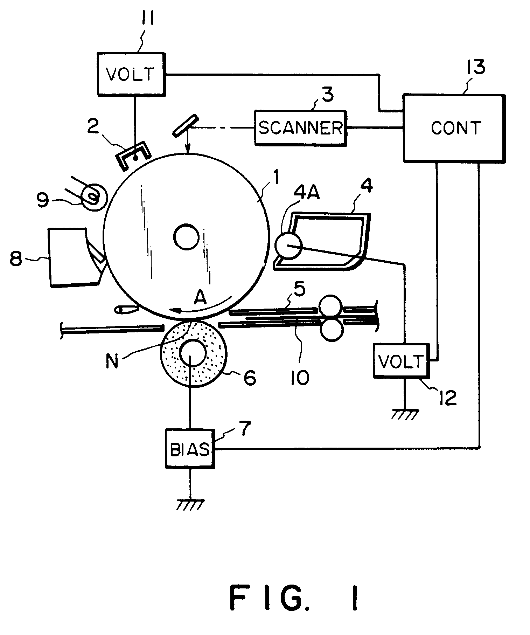

Referring to Figure 1, there is shown an image forming apparatus usable with the present invention. The image forming apparatus comprises a photosenstive member 1 extending in a direction perpendicular to the sheet of the drawing and rotatable in a direction indicated by an arrow A. The surface of the photosensitive member 1 is uniformly charged by a corona charger 2, and thereafter, light is projected thereonto in accordance with an image signal, so that an electrostatic latent image is formed. When the latent image reaches a developing device 4, the latent image is visualized with the toner.

When the toner image reaches a nip N formed between the photosensitive member 1 and a transfer roller 6 (charging electrode) made of conductive rubber, a recording material 10 reaches the nip N because it is supplied thereto through a conveyance passage 5 with timed relation with the latent image. Then, a transfer bias is applied to the transfer roller 6 from a power source 7, so that the toner image is transferred onto the recording material. Referring back to the charger 2, it is supplied with a voltage for charging the photosensitive member (image bearing member) 1 from the power source 11, whereas a developing sleeve 4A of the developing device 4 is supplied with a developing bias voltage from a power source 12.

The recording material discharged from the nip N is further advanced in the leftward direction to an unshown image fixing station, where the unfixed toner image on the recording material 10 is fixed thereon.

The toner on the photosensitive member 1 which is not transferred to the recording material during the transfer operation reaches with rotation of the photosensitive member to a cleaning device 8 where remaining toner is removed from the photosensitive member. The electric charge remaining on the surface of the photosensitive member is erased by illumination by a discharging lamp 9, so that the photosensitive member 1 is prepared for the next image forming operation.

The image forming apparatus shown in the Figure is a laser beam printer of an electrophotographic type. The latent image formation and image transfer therein will be described. The photosensitive member 1 is provided with an organic photoconductor (OPC) layer and is charged to -700 V by the corona charger 2 and is exposed by a laser scanning device 3 to a laser beam modulated in accordance with an image signal by a controller 13. Such an area of the photosensitive member 1 as will become an image portion (characters or the like) after development is exposed to the laser beam. By the image exposure, the image portion potential attenuates to -100 V, so that a latent image is formed. In the developing device 4, the toner having been charged to the same polarity as the charge applied to the photosensitive member 1 by the corona charger 2, that is, negatively charged toner is supplied thereto, whereby the toner is deposited to such an area where the potential is attenuated by the application of the laser beam, so that a toner image is formed. That is, the latent image is reverse-developed. The toner image now formed on the photosensitive member 1 reaches, with rotation of the photosensitive member 1, to the nip N, where a recording material 10 supplied through the conveyance passage 5 is contacted to the photosensitive member 1, so that the recording material 10, the photosensitive member 1 and the transfer roller are advanced at the same speed. The transfer roller 6 is supplied with a transfer bias of +500 V (the polarity opposite to the charge of the toner) from the power source 7, by which an image transfer electric field is formed, so that the toner image is transferred from the photosensitive member 1 to the transfer material 10.

The material of the photosensitive member 1 described above is not limiting, but may be amorphous silicon, selenium, ZnO or the like.

As will be understood from Figure 1, the power source 11 for the corona charger 2, the laser exposure device 3, the power source 12 for the developing sleeve 4A and the power source 7 for the transfer roller 6 are on-off controlled by the controller 13. In this embodiment, a non-image formation area (an area which is to correspond to non-passage of the transfer material when it reaches to the transfer station, or an area which is to correspond to non-exposure period of the photosensitive member to the light information), is not subjected to the charging operation, since the charger 2 is not energized, whereby the surface potential of the photosensitive member 1 in such an area is 0 V.

During the period in which the non-charged region having the surface potential of 0 V is in the developing zone where it is opposed to the developing device, the developing bias applied to the developing sleeve is not supplied, or otherwise, the developing bias is switched to a positive polarity, to prevent deposition of the toner to the photosensitive member 1.

In a printer using a laser beam, the quantity of laser output varies in dependence on the temperature and humidity. To compensate this, it is usual that the laser beam is continuously produced, and the amount of light is detected, during non-image formation period (between adjacent printing periods in the case of continuous printing, or pre-rotation period in the case of one print) to maintain a constant quantity of light. If the photosensitive member 1 is charged when supplied with the laser beam application for the constant quantity maintenance of the laser beam light, the potential of the portion exposed to the laser beam attenuates, and therefore, two surface potential portions, i.e., -700 V and -100 V are produced. It is difficult to provide a developing bias which prevents deposition of the toner to both of the areas due to a problem of production of a foggy background attributable to reversely charged toner which is charged to a polarity opposite to the polarity of almost all of the toner particles and which is possibly contained in the developer and due to the problem of deposition of carrier particles (when the developer is constituted by toner particles and carrier particles charged to a polarity opposite to that of the toner particles). In this embodiment, however, the surface potential of the photosensitive member is zero, and therefore, the bias voltage preventing the toner deposition can be selected from a wide range.

For example, when a magnetic brush development using a DC bias voltage and using a two component developer (containing toner and carrier particles) is employed the developing bias for the non-image formation area can be selected from a range of several hundreds volts when the surface potential of the photosensitive member is near 0 V, from the standpoint of prevention of deposition of the developer to the photosensitive member.

In the case where a so-called jumping development wherein a one component insulative magnetic developer is used, and a thin developer layer on the developing sleeve is opposed to the photosensitive member with a clearance in the developing zone, where an alternating electric field formed by superposing an AC voltage and a DC voltage is applied across the developing zone, the developing bias for preventing toner deposition to the photosensitive member can be selected from wide variations including the weakening only of the peak-to-peak voltage of the AC voltage component for the non-image formation area, the shutting-off thereof for the non-image formation area, the changing of the DC component for the non-image formation area, or shutting-off both of them. By this, the contamination of the transfer roller contacted to the non-image formation area of the photosensitive member 1 can be prevented.

When the non-image formation area of the photosensitive member 1 is in the image transfer region where the photosensitive member 1 and the transfer roller 6 are press-contacted, that is, during the non-transfer operation, further in other words, when the recording material is not passed through the transfer region, the photosensitive member 1 directly contacts the transfer roller 6, which supplied with a bias voltage of the same polarity as the toner, for example, -500 V to drive the negative toner from the transfer roller 6 to the photosensitive member 1. In other words, the absolute value of the surface potential of the photosensitive member 1 during the non-passage of the recording material is smaller than the absolute value of the bias voltage applied to the transfer roller 6.

Since the surface potential of the photosensitive member 1 is 0 V, for example, an electric field sufficient for transferring the toner from the transfer roller 6 to the photosensitive member 1 is formed with a relatively low voltage, so that the transfer roller 6 is satisfactorily cleaned.

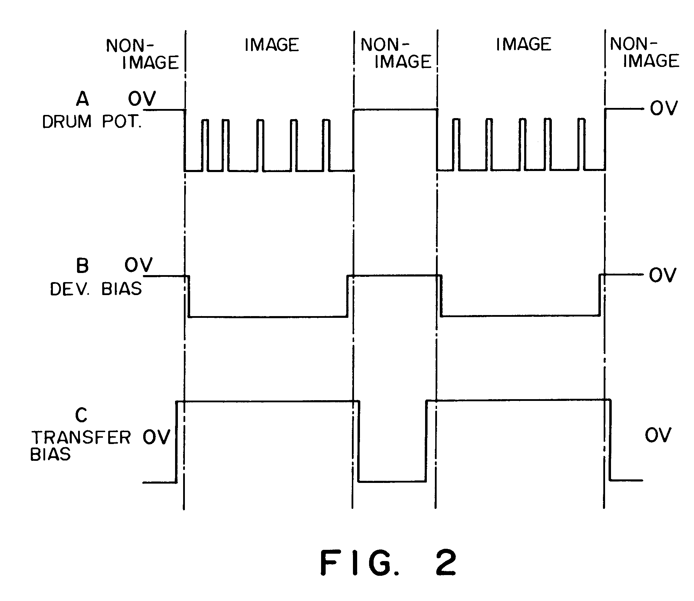

Referring to Figure 2, there is shown a timing chart illustrating an operation of the apparatus according to this embodiment, wherein reference A indicates a surface potential of the photosensitive member 1, and the pulse-like portion in the image area indicates a potential pattern provided by the information light application.

Reference character B indicates switching of the developing bias. In the timing of the developing bias application for normal image formation, the non-charged portion is to receive the toner, and therefore, in this embodiment, the switching of the bias voltage is to overlap with the non-passage of the transfer material through the nip between the photosensitive member 1 and the transfer roller 6, that is, the non-image non-charge area.

Reference character C designates timing of the switching of the bias voltage to the transfer roller. The bias voltage is positive when the transfer roller 6 is opposed to the image area of the photosensitive member 1 (during passage of the transfer material), and is negative when the transfer roller 6 is opposed to the non-image area (during the transfer material is not passed).

As described, the developing bias is switched so as to be overlapped with the non-charge portion from the standpoint of deposition of the toner to the photosensitive member 1. Adjacent starting and terminating points of time, the developing bias voltage becomes 0 V under the condition that the surface potential of the photosensitive member is -700 V, and therefore, the normally charged (negative in this case) toner is prevented from deposition. However, a reversely charged toner (positive charged in this case) in the one component developer or the carrier particles positively charged in the two component developer can be deposited to the photosensitive member in the developing device, because a strong reverse electric field is formed for a short period of time. If a bias voltage having the same polarity as the normal toner as described in the foregoing is applied to the transfer roller 6 in the neighborhood where the reversely charged toner or the like is deposited on the photosensitive member, the reversely charged toner and/or the carrier can be transferred back to the transfer roller 6 and can contaminate it. Therefore, it is preferable that the polarity of the bias to the transfer roller is switched to the same as the normal toner, when the no-charge portion is opposed to the transfer roller, since there the reversely charged toner or the like is not deposited to the photosensitive member.

In the foregoing embodiment, the charger is stopped at the non-image formation area of the photosensitive member 1 (the area of the photosensitive member opposed to the transfer roller when the transfer material is not passed through the nip), but, the charging voltage of the charger may be made smaller than for the image area, or alternatively, a bias voltage for a grid, if it is provided for the corona charger, or may be controlled to decrease the potential of the non-image formation area of the photosensitive member 1.

As a further alternative, it is possible that the non-image formation area of the photosensitive member 1 is once charged by the charger to the same extent as the image formation area, and thereafter, the charge in the non-image formation area of the photosensitive member may be removed or decreased. For example, the potential may be decreased by applying light to the non-image region of the photosensitive member which has once been charged. The potential of the non-image formation area of the photosensitive member is not limited to be 0 V. However, it will suffice if the absolute value of the surface potential of the photosensitive member corresponding to the non-passage of the transfer material is smaller than the absolute value of the bias voltage applied to the transfer roller, when the transfer roller is cleaned.

In the case of increasing the bias voltage applied to the transfer roller 6 rather than decreasing the surface potential of the non-image formation area of the photosensitive member as compared with the image formation area, a high bias voltage is required to be applied to the transfer roller in order to provide a sufficient potential contrast for satisfactorily cleaning the transfer roller. For example, when the surface potential of the photosensitive member 1 is maintained at -700 V in the foregoing embodiment, the bias voltage to the transfer roller is required to be -1200 V, in order to form an electric field to transfer the toner from the transfer roller 6 to the photosensitive member 1 by application of a negative (the same as the polarity of the toner) bias voltage to the transfer roller 6. In order to apply such a high voltage to the transfer roller 6, the power source device becomes bulky, or another problem of leakage of high voltage results.

In order to avoid this, the embodiment of the present invention decreases the potential of the region of the photosensitive member to be opposed or contacted to the transfer roller during non-passage of the transfer material at the transfer station. Further preferably, the potential thereof is 0 V, since then the voltage applied to the transfer roller 6 is small, and the possibility of dielectric break-down of the photosensitive member is reduced, and leakage of current can be prevented. This is particularly effective when the photosensitive member (image bearing member) is of amorphous silicon, OPC or the like having a relatively low durability to the dielectric breakdown.

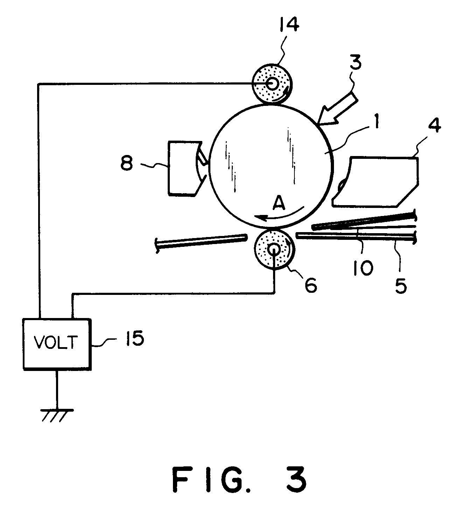

Referring to Figure 3, there is shown an image forming apparatus according to another embodiment of the present invention, wherein in place of the corona charger 2 of Figure 1, a charging roller 14 is employed which is made of a conductive rubber and is connected with a source 15 and which is contacted to the photosensitive member 1. The charging roller 14 constitutes a contact type charging device to uniformly charge the surface of the photosensitive member 1. The charging roller 14 is electrically conductive at least a surface thereof, and the resistance is preferably 10² - 10⁸ ohm.cm, more particularly, it is a roller of electrically conductive urethane rubber having a resistance of 10⁵ ohm.cm in this embodiment.

In operation, the charging roller 14 is supplied from a power source 15 with a vibratory voltage provided by superimposing a DC voltage of -700 V and an AC voltage having a peak-to-peak voltage of 1500 V and a frequency of 1000 Hz, by which the photosensitive layer of the surface of the photosensitive member 1 can be uniformly charged to -700 V. Here, the vibratory voltage means a voltage in which the level of the voltage periodically changes with time, and the waveform thereof may be triangular, rectangular or pulse-like.

A light image is applied to the surface thus charged so that a latent image is formed, and the latent image is reverse-developed so that negatively charged toner particles are deposited to such an area of the latent image as is exposed to the light and is decreased in the potential, whereby a toner image is formed.

A transfer material 10 is supplied to the photosensitive member in alignment with the toner image. During the transfer operation, the transfer roller 6 is supplied with a DC bias voltage of +500 V, by which a good transferred image can be provided on the transfer material 10.

During non-transfer operation, that is, while the transfer material is not present between the photosensitive member 1 and the transfer roller 6, the transfer roller 6 is supplied with -500 V. In addition, for the area of the photosensitive member 1 which is to be opposed to the transfer roller 6 during the non-transfer operation, the DC component of the voltage applied to the charging roller is shut-off, so that only an AC component is applied, by which the surface of the photosensitive member is uniformly electrically discharged to 0 V.

When image forming operation is repeated with the above-described structure, potential contrast of the latent image due to the remaining charge is present, in the area of the photosensitive member 1 upstream the charging roller 14 with respect to rotation of the photosensitive member 1, but in the area downstream thereof, the entire surface is uniformly charged to -700 V, so that a pre-exposure lamp which having been required in the conventional apparatus is not necessarily required. This is confirmed through experiments.

The voltage applied to the charging roller 14 may be constituted only with a DC voltage. However, in order to charge the surface of the photosensitive member to -700 V, a DC voltage of -1200 - -1300 V is required, and in addition, the uniformness of the surface potential is slightly poorer than when a superposed AC and DC voltage is used with the result that production of a ghost image can not be avoided without provision of the pre-exposure lamp. Therefore, better results can be provided when the superposed voltage is applied to the charging roller 14 than when only a DC voltage is applied.

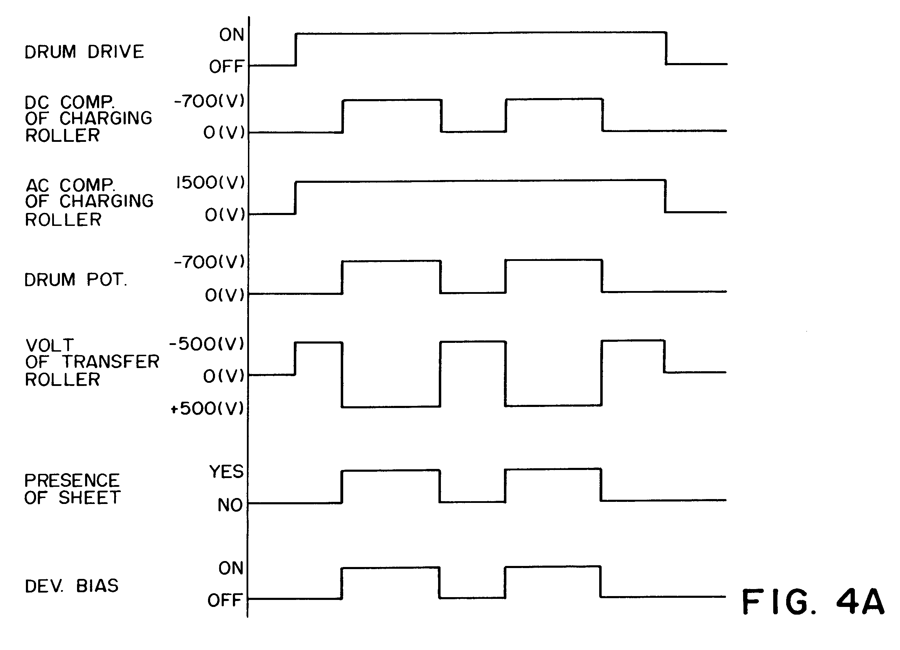

Figure 4A shows a sequential operation of application of the voltage during charging, developing and image transferring operations. In this Figure, the time lag resulting from movement of the photosensitive member is omitted. For example, since the time required for a portion of the photosensitive member to move from the charging position to the image transfer position is omitted, it should not be understood in Figure 4A that the application of the voltage of -700 V for the DC component to the charging roller 14 is simultaneously with initiation of application of the voltage of 500 V to the transfer roller.

In Figure 4A, during the non-transfer operation in which the transfer material is not present in the nip, the DC component to the charging roller 14 is made 0 V, by which the surface potential of the photosensitive member 1 is made 0 V, and also, the bias voltage to the transfer roller 6 is made -500 V, by which the negatively charged toner can be assuredly transferred to the photosensitive member. In this portion, it is preferable that the developing bias is made zero, since then the toner is not transferred without charging.

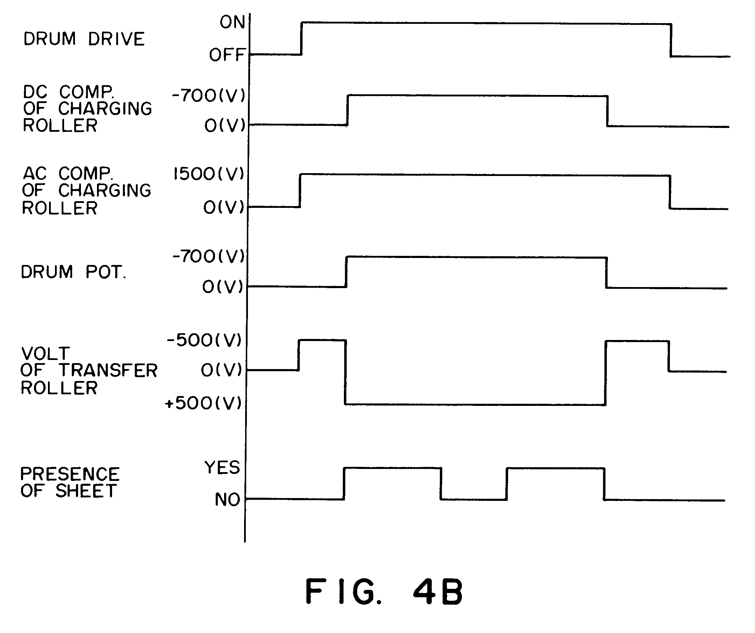

Since the transfer roller is mainly contaminated by jam or malfunction, the potentials of the charging roller 14 and the transfer roller 6 may be controlled only during the pre-rotation period or post-rotation period, as shown in Figure 4B. Without changing the potentials of the rollers during the non-passage of the transfer material between adjacent transfer material passages in the continuous image forming operation, thus performing no cleaning of the transfer roller, a good image can be provided. It is possible that the cleaning of the transfer roller in the manner described above is performed during a part of the non-passage period.

The voltage source for applying bias voltage to the transfer roller 6 may be common with the power source for applying a voltage to the charging device, and the intended performance can be provided by a relatively low voltage source, whereby the size of the apparatus can be reduced.

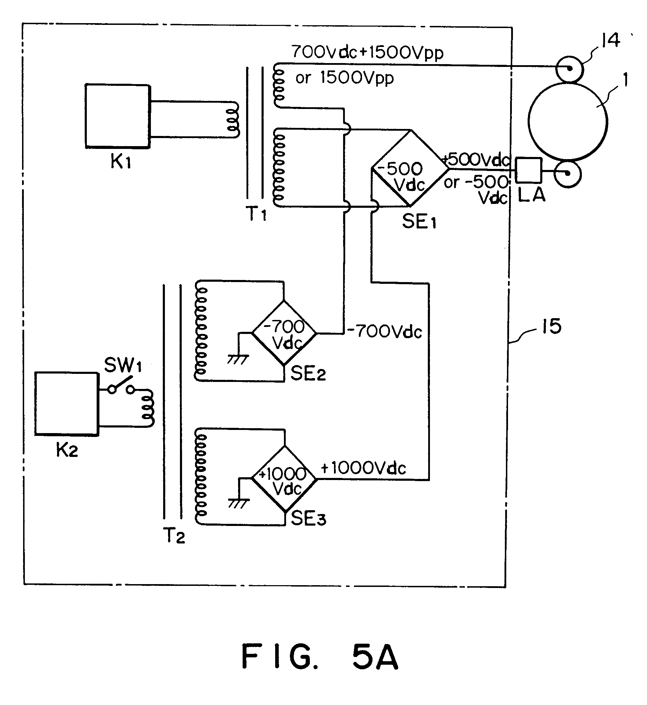

Referring to Figure 5A, there is shown an example of a structure of the power source 15. When a switch SW1 of a driver circuit K2 is actuated, a voltage of -700 V is produced through a transformer T2 and a rectifier SE2, and a voltage of +1000 V is produced through a rectifier SE3. A driver circuit K1 always produces an alternating voltage whenever the photosensitive member is driven, and a voltage of 1500 V (peak-to-peak voltage) is produced through a transformer T1, and a voltage of -500 V is produced by a rectifier SE1.

Therefore, by actuating the switch SW1, a superimposed voltage of -700 V (DC) and 1500 V (AC, peak-to-peak voltage), is applied to the charging roller 14, +500 V is applied to the transfer roller 6.

In order to clean the transfer roller 6, the switch SW1 is rendered off, by which only an AC voltage of peak-to-peak voltage of 1500 V is applied to the charging roller 14, and -500 V is applied to the transfer roller 6, whereby the negatively charged toner is returned to the photosensitive member 1.

Since it requires a certain time for a portion of a surface of the photosensitive member 1 moving from the position of the charging roller 14 to the position of the transfer roller 6, it is preferable to provide a delaying circuit LA in the transfer roller 6 side to compensate the time lag.

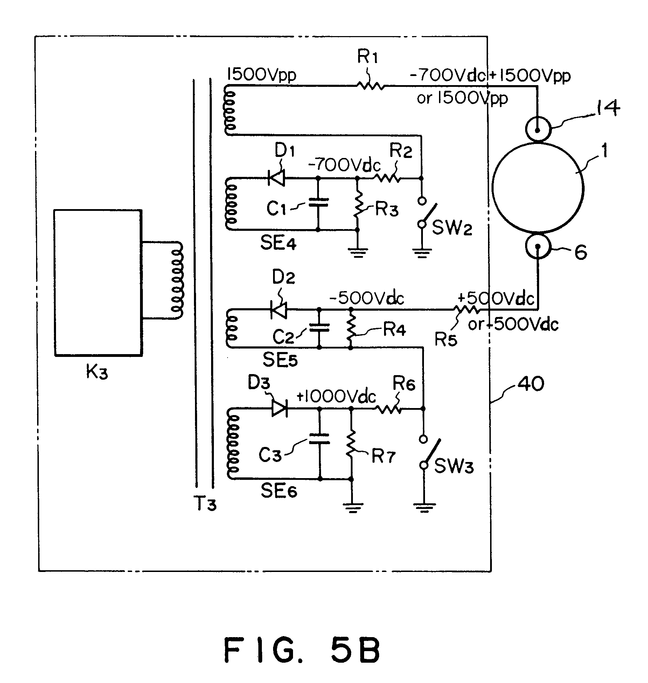

Figure 5B shows another example of the power source, wherein references D1, D2 and D3 designate diodes; C1, C2 and C3 capacitors; and R1 and R7 registers.

The driving circuit K3 always produces an alternating voltage whenever the photosensitive member 1 is driven.

By opening the switch SW2, the charging roller 14 is supplied through a transformer T3 with a superposed voltage of an AC voltage having a peak-to-peak voltage of 1500 V and a DC voltage of -700 V produced by a rectifier SE4. By closing the switch SW2, it is supplied only with a DC voltage of 1500 V.

By opening the switch SW3, the transfer roller 6 is supplied with +500 V, while by closing the switch SW3, it is supplied with -500 V.

In this device, only one transformer is necessitated, and a half-wave rectifier which is less expensive is used, and therefore, the cost can be decreased.

In the foregoing embodiments, the DC component of the charging roller 14 is rendered 0 V during the cleaning operation of the transfer roller 6, it may be, as described hereinbefore, made higher than the voltage (-500 V in the examples) applied to the transfer roller 6, for example, it may be made -100 V.

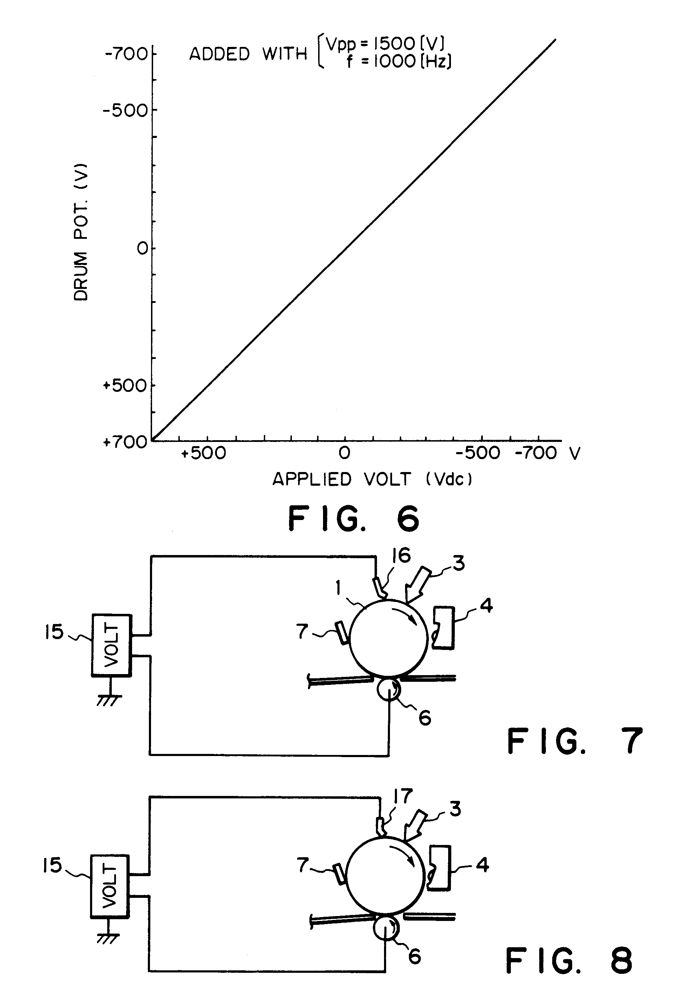

Figure 6 is a graph showing change of the surface potential of the photosensitive member 1 relative to change of the DC component of the voltage applied to the charging roller 14 with the AC component being fixed to be 1500 V of the peak-to-peak voltage and 1000 Hz of the frequency.

From this, it is understood that the surface potential can be freely changed so that the DC component and the surface potential of the photosensitive member can be made equivalent so as to sufficiently clean the transfer roller 6, and therefore, the charging roller 14 is very advantageous over the corona charger 2.

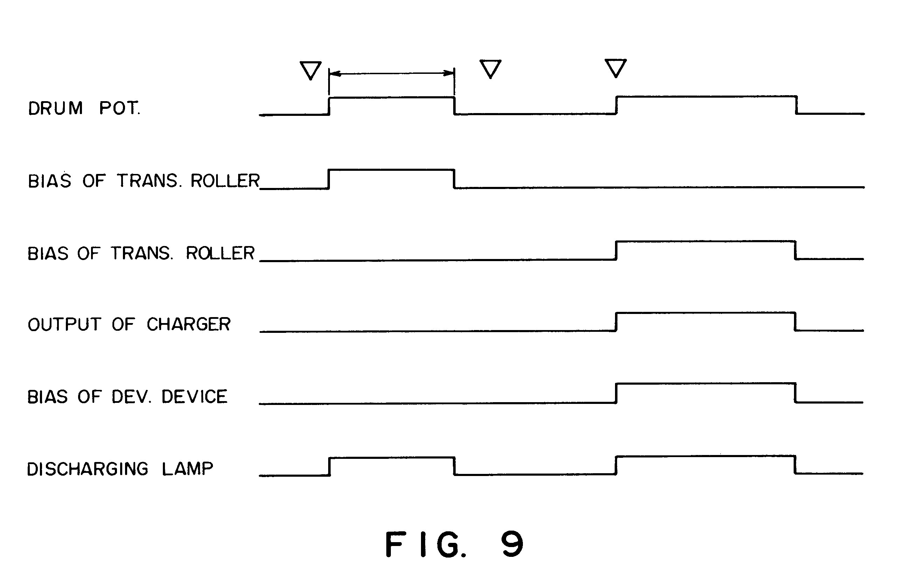

Figures 7 and 8 show further embodiments. In Figure 7, the means for uniformly charging the photosensitive member is a blade 16 made of conductive rubber. In Figure 8, it is a conductive brush 17. Both of them are in sliding contact with the photosensitive member 1. With these structures, the same effects can be provided as described above.

In the manner described above, the image forming operation and the image transfer operation are repeated. Also as mentioned hereinbefore, when the image forming operation is resumed after temporary stop of the apparatus due to jam occurrence or the like, the toner deposited on the portion of the photosensitive member where the toner image has been formed by the developing device 4 prior to the stoppage and where the toner image has not yet been transferred is directly contacted to the transfer roller 6 at the initial stage of the resumption, and therefore, the toner is directly transferred onto the transfer roller 6.

In order to obviate this problem, it is possible that warming up time period is provided when the power supply is resumed after interruption of the power supply due to jam occurrence or the like, and that an electric field is created for transferring the toner from the transfer roller 6 to the photosensitive member, by which the transfer roller 6 is cleaned.

In connection with the embodiment of Figure 1, the transfer roller 6 is supplied with -500 V having a polarity which is the same as that of the negatively charged toner, and the operations of the charger 2 and the developing device 4 are stopped, whereas only the discharging lamp 9 is operated, so that the surface potential of the photosensitive member 1 is attenuated down to 0 V. Such a warming up period is continued at least during a period from a point of time when a certain point on the photosensitive member 1 is at the developing device 4 to the point of time when it reaches the nip N between the transfer roller 6 and the photosensitive member 1.

In the embodiment of Figure 1, assuming that the diameter of the photosensitive member 1 is 60 mm, and the peripheral speed thereof is 20 mm/sec, the warming up period is selected as to be not less than 3 seconds, and after the warming up period, the apparatus is placed in a stand-by period in which the image forming operation is possible.

With this structure, even in the case where the image forming operation is once stopped, and is resumed, the toner image formed between the developing station and the transfer station is not transferred to the transfer roller 6, and is passed through the transfer station as it is to reach the cleaning device, and is removed thereby, and therefore, it can be avoided that such toner is deposited to the transfer roller 6 and contaminates the subsequent transfer material.

Figure 9 is a timing chart showing an example of such an image forming apparatus. By selecting the warming-up time period so as to be longer than the time required for the transfer roller 6 to rotate through one full turn, the transfer material 10 can be prevented from contamination with the toner which is already deposited on the transfer roller 6 at the time of the re-supply of the power, due to toner particles suspending in the apparatus.

In this case, the diameter of the transfer roller 6 is 30 mm, and the peripheral speed is the same as that of the photosensitive member, the warming-up period is not less than 5 seconds. In the description of the foregoing embodiments, the photosensitive member 1 is negatively charged, and the latent image is reverse-developed with negatively charged toner, but the same concept is applicable to the case where the latent image is regularly developed.

For example, the photosensitive member is charged to -700 V, and the laser scanning device 3 applies light modulated in accordance with an image signal to project light to the white area, by which a latent image is formed on the photosensitive member, and the latent image is regularly charged by positively charged toner with a DC developing bias of -300 V. The transfer roller is supplied with a transfer bias voltage of -1500 V, so as to transfer the toner image from the photosensitive member 1 to the transfer material 10.

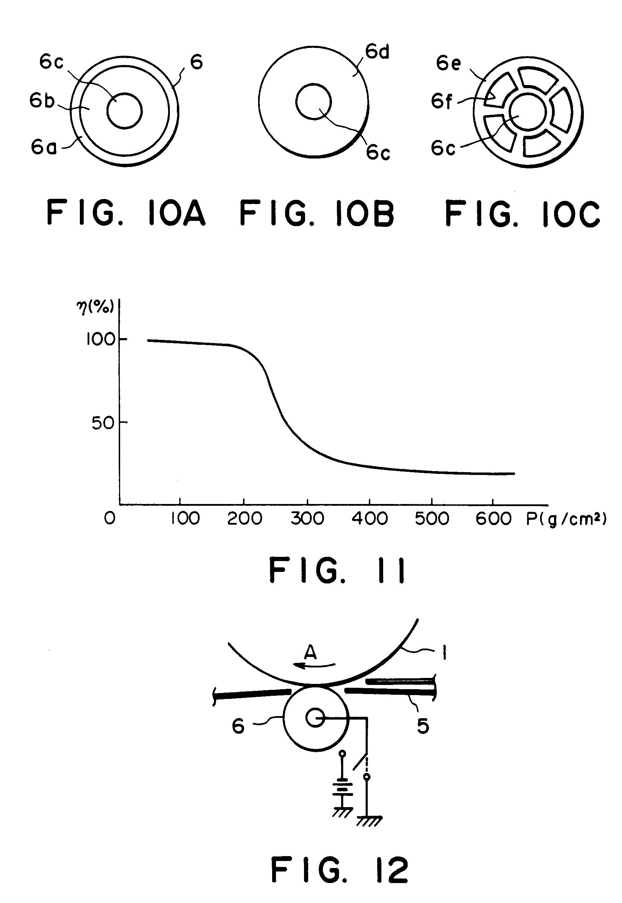

In this case, in order to clean the transfer roller 6, a bias voltage having the same polarity as the positively charged toner is applied to the transfer roller 6 during the non-transfer operation, and the region of the photosensitive member 1 which is opposed to the transfer roller 6 during the non-transfer operation is made to have a voltage of approximately 0 V by controlling the charger 2. Because it is about 0 V, it is not developed by the positively charged toner. By making the bias voltage to the transfer roller 6 during the non-transfer operation the same as the positively charged toner, the transfer roller 6, in effect, applies to the photosensitive member 1 the electric charge having the polarity opposite to the charge polarity (negative) for charging the photosensitive member 1 by the charger 2. When the electric charge having the polarity opposite to the charging polarity of the photosensitive member 1 is deposited on the photosensitive member 1, the charge can not be erased even by the discharging lamp 9, and therefore, it remains as a memory in the next image. Therefore, it is preferable that the bias voltage to the transfer roller 6 during the non-transfer operation is preferably 0 V (Figure 12) or has a polarity opposite to that of the toner. At this time, the region of the photosensitive member 1 which is to be opposed to the transfer roller 6 during the non-transfer operation is charged by the charger 2 to such a level as is higher than the charging level during the image formation, for example, -900 V and on the other hand, the developing bias of the developing device 4 is made near -900 V. By doing so, an electric field for transferring the positively charged toner from the transfer roller 6 to the photosensitive member 1 is formed, and therefore, similarly to the case described above, the contamination of the transfer material 10 can be prevented.

It has been found that when the image transfer operation is executed in the apparatus described above, the amount of the toner which is once deposited on the transfer roller 6 and is transferred to the photosensitive member 1 is significantly varied depending on the press-contact pressure between the transfer roller 6 and the photosensitive member 1.

Figure 10A shows a transfer roller 6 which comprises a metal core 6c, and inside layer 6b made of conductive urethane sponge and an outside layer of solid urethane rubber having electrical conductivity.

Figure 11 shows change of the cleaning efficiency relative to the contact pressure between such a transfer roller 6 and the photosensitive member 1. The transfer efficiency is defined by a percentage of the amount of the toner transferred to the photosensitive member 1 when the transfer roller 6 having toner particles deposited thereon is rotated through three full turns.

As will be understood from Figure 11, the cleaning efficiency is significantly improved when the contact pressure is not more than 300 g/cm².

Using the above-described transfer roller 6, when the contact pressure between the transfer roller 6 and the photosensitive member 1 was set 200 g/cm², the nip width of 2 mm could be provided, and the image transfer properties and the sheet conveying properties were without problem, and the cleaning of the transfer roller 6 was so good that the backside of the transfer material was not contaminated. If the contact pressure was decreased, the nip width was decreased, and therefore, the image transfer became insufficient, and the image can be blurred. In view of this, it is preferable that the hardness (JIS (Japanese Industrial Standard) A) of the transfer roller 6 is not more than 30 degrees. Further in view of this, the roller is of a two layer structure wherein the outside layer surface is made smooth, and the hardness thereof is slightly larger so as to prevent the toner from wedging into the roller surface and so as to increase the durability of the roller, whereas the hardness of the inside layer is made lower to provide the entire hardness in the preferable range. The measurement of the roller hardness was performed in accordance with JIS K-6301 using a JIS-A hardness measuring device (TECLOCK GS-706 available from TECLOCK).

Figures 10B and 10C show another examples of transfer rollers 6. In Figure 10B, it is made of a sponge-like conductive urethane rubber 10d having fine pores with pore diameter of approximately 10 microns. In Figure 10C, it is made of a conductive rubber 6e having plural cavities6f therein. With those rollers, the same effects can be provided as the transfer roller 6 shown in Figure 10A.

Further, it is preferable that a surface roughness of the transfer roller 6 is not more than the average particle size of the used toner particles, usually not more than 10 microns, the surface roughness being determined on the basis of ten point average method, since then the image transfer efficiency is improved.

An example of such a transfer roller 6 can be made by adding a foaming agent into urethane which is made electrically conductive by dispersing and mixing thereinto carbon, and it is foamed in a hollow cylindrical metal mold. By doing so, the surface of the produced roller follows the inside surface of the metal mold to become a skin layer having a surface roughness not more than 10 microns (ten point average measurement), and the roller is electrically conductive.

The measurement of the surface roughness of the transfer roller 6 is performed in accordance with JIS-B-0601 using a surface configuration measuring device SE-3C available from Kosaka Laboratories, Japan.

The transfer roller was produced, having a core metal having a diameter of 6 mm, wrapped with foamed urethane having a conductivity of 10² ohm.cm (volume resistivity) and having a thickness of 5 mm. The transfer roller thus had a diameter of 16 mm. The transfer roller 6 was produced in the manner described above, the surface thereof was abraded to provide the surface roughness Rz of 2s (A) and 10s (B). The roller was press-contacted to an OPC photosensitive drum having a diameter of 30 mm with a total pressure of 600 g, wherein the press-contacted area therebetween was 21 cm x 0.1 cm. A latent image having a dark potential of -700 V and light potential of -100 V was formed and was developed reversely with negative toner particles having an average particle size of 12 microns. During the image transfer operation, the transfer roller was supplied with +500 V. During the non-transfer operation, the transfer roller was cleaned in the manner described above, the transfer efficiency did not decrease even after several hundreds sheets were processed. The surface of the roller after the test was almost the same as prior to the test.

The transfer roller described above was the one press-contacted to the photosensitive member. However, it is possible to provide a small clearance depending on the thickness of the transfer material, between the transfer roller surface and the photosensitive member surface so that during the transfer operation (passage of the transfer material) the transfer roller press-contact the transfer material to the photosensitive member, whereas during the non-transfer operation, the toner deposited on the transfer roller is transferred to the photosensitive member through the small clearance.

As for the image bearing member, it is not limited to the photosensitive member, but it is possible to use an insulating drum. The transfer means is not limited to the transfer roller, but it may be in the form of an endless belt.

It is understood that the application of the present invention is not limited to the cleaning of the transfer means, but is applicable to charging means for charging the image bearing member, for example, the charging roller 14 described above.

As described in the foregoing, according to the present invention, by changing the potential of the image bearing member opposed to the charging electrode, an electric field effective to transfer the toner from the charging electrode to the image bearing member, and the transfer means can be effectively cleaned, by which a good quality of the image can be provided.

While the invention has been described with reference to the structures disclosed herein, it is not confined to the details set forth and this application is intended to cover such modifications or changes as may come within the purposes of the improvements or the scope of the following claims.

## Claims

1. An image forming apparatus, comprising: a movable image bearing member (1); a first potential application means (2, 14) for electrically charging said image bearing member to a first potential; latent image forming means (3) for forming a latent image on the image bearing member; toner image forming means (4) for forming a toner image on said image bearing member by developing the latent image with toner which is electrically charged; transport means for delivering a recording material (10) to an image transfer position; and image transfer means (6) contactable to the rear of a recording material at said transfer position to transfer the toner image from said image bearing member to the recording material; second potential application means (7) for applying a second potential to said transfer means (6) when the recording material is not at the image transfer position; and a control means (13) capable of controlling the first and second potential application means;
characterised in that a potential providing means (2, 11, 13; 9, 13; or 3, 13) is included for providing a third potential onto a portion of the image bearing member to be opposed to the image transfer means (6) during its non-transfer action, and in that said control means (13) serves to operate said first and second potential application means and said potential providing means such that said second potential application means applies said second potential to said transfer means (6) when the recording material is not at the transfer position, said potential providing means (9, 13) providing said third potential on that portion of said image bearing member (1) which is to be presented to the transfer position during the application of the second potential by said second application means, wherein said third potential is at a different voltage level to that of the first potential and is remote from the first potential in a direction opposite from that of the polarity of the electrical charge of the toner, whereby an electric field for transferring the toner from said transfer means to said image bearing means is formed by said second potential and said third potential.

2. An apparatus as claimed in claim 1, characterised in that said second potential application means provides said second potential at a polarity which is the same as that of toner charge.

3. An apparatus as claimed in claim 1 or 2, characterised in that said first potential application means provides the first potential at a polarity which is the same as that of toner charge.

4. An apparatus as claimed in claim 1 or 2, characterised in that said potential providing means provides said third potential which absolute value is lower than the absolute value of said second potential.

5. An apparatus as claimed in claim 1 or 2, characterised in that the potential providing means provides said third potential at a polarity which is the same as that of the first potential and with an absolute value higher than that of the first potential.

6. An apparatus according to any one of claims 1 to 5, characterised in that said first potential application means (2, 11, 13; 14, 11, 13) also functions as said potential providing means.

7. An apparatus according to claim 6, characterised in that said control means is arranged to switch said first potential application means to a non-charging state so that a non-image carrying portion of said image bearing member is not charged.

8. An apparatus according to claim 5, characterised in that said potential providing means also functions to remove electric charge from said non-image carrying portion of said image bearing member (1).

9. An apparatus as claimed in claim 8, characterised in that said image bearing member (1) includes a photosensitive member, and the potential providing means includes means (9) for projecting light to said photosensitive member.

10. An apparatus as claimed in claims 1 to 9, characterised in that said transfer means (6) is contactable with said image bearing member (1).

11. An apparatus as claimed in claims 1 to 10, characterised in that the absolute value of said third potential is lower than the absolute value of said second potential.

12. An apparatus as claimed in claims 1 to 11, characterised in that said transfer means (6) is press-contacted to said image bearing member (1) with a pressure not more than 300 g/cm².

13. An apparatus as claimed in claims 1 to 12, wherein said image transfer means has a hardness of not more than 30 degrees (Japanese Industrial Standard A).

## Patentansprüche

1. Bilderzeugungsgerät mit einem bewegbaren Bildträgerteil (1), einer ersten Potential-Anlegevorrichtung (2, 14) zum elektrischen Aufladen des Bildträgerteils auf ein erstes Potential, einer Latentbild-Erzeugungsvorrichtung (3) zum Erzeugen eines Latentbildes auf dem Bildträgerteil, einer Tonerbild-Erzeugungsvorrichtung (4) zum Erzeugen eines Tonerbildes auf dem Bildträgerteil durch Entwickeln des Latentbildes mit Toner, der elektrisch aufgeladen ist, einer Transportvorrichtung zum Fördern eines Aufzeichnungsmaterials (10) zu einer Bildübertragungsposition, einer Bildübertragungsvorrichtung (6), die die Rückseite des Aufzeichnungsmaterials an der Übertragungsposition zum Übertragen des Tonerbildes von dem Bildträgerteil zu dem Aufzeichnungsmaterial berühren kann, einer zweiten Potential-Anlegevorrichtung (7) zum Anlegen eines zweiten Potentials an die Übertragungsvorrichtung (6), wenn sich das Aufzeichnungsmaterial nicht an der Bild-Übertragungsposition befindet, und einer Steuervorrichtung (13), die die erste und zweite Potential-Anlegevorrichtung steuern kann,
**dadurch gekennzeichnet, daß**
eine Potential-Erzeugungsvorrichtung (2, 11, 13; 9, 13; 3, 13) zum Erzeugen eines dritten Potentials an einem Abschnitt des Bildträgerteils enthalten ist, der der Bildübertragungsvorrichtung (6) während ihres Nicht-Übertragungsvorgangs gegenüberliegt, und daß die Steuervorrichtung (13) zum Betreiben der ersten und zweiten Potential-Anlegevorrichtung und der Potential-Erzeugungsvorrichtung derart dient, daß die zweite Potential-Anlegevorrichtung das zweite Potential an die Übertragungsvorrichtung (6) anlegt, wenn sich das Aufzeichnungsmaterial nicht an der Übertragungsposition befindet, wobei die Potential-Erzeugungsvorrichtung (9, 13) das dritte Potential an dem Abschnitt des Bildträgerteils (1) erzeugt, der während des Anlegens des zweiten Potentials durch die zweite Potential-Anlegevorrichtung in die Übertragungsposition gebracht wird, wobei das dritte Potential auf einem unterschiedlichen Spannungspegel als das des ersten Potentials ist und von dem ersten Potential in einer umgekehrten Richtung von dem der Polarität der elektrischen Ladung des Toners entfernt ist, wodurch ein elektrisches Feld zum Übertragen des Toners von der Übertragungsvorrichtung zu dem Bildträgerteil durch das zweite Potential und das dritte Potential erzeugt wird.

2. Gerät nach Anspruch 1, **dadurch gekennzeichnet, daß** die zweite Potential-Anlegevorrichtung das zweite Potential mit einer Polarität erzeugt, die dieselbe wie die der Ladung des Toners ist.

3. Gerät nach Anspruch 1 oder 2, **dadurch gekennzeichnet, daß** die erste Potential-Anlegevorichtung das erste Potential mit einer Polarität erzeugt, die dieselbe wie die der Ladung des Toners ist.

4. Gerät nach Anspruch 1 oder 2, **dadurch gekennzeichnet, daß** die Potential-Erzeugungsvorichtung das dritte Potential erzeugt, dessen Absolutwert geringer als der Absolutwert des zweiten Potentials ist.

5. Gerät nach Anspruch 1 oder 2, **dadurch gekennzeichnet, daß** die Potential-Erzeugungsvorrichtung das dritte Potential mit einer Polarität, die dieselbe wie die des ersten Potentials ist, und mit einem Absolutwert erzeugt, der höher als der des ersten Potentials ist.

6. Gerät nach einem der Ansprüche 1 bis 5, **dadurch gekennzeichnet, daß** die erste Potential-Anlegevorrichtung (2, 11, 13; 14, 11, 13) auch als die Potential-Erzeugungsvorrichtung dient.

7. Gerät nach Anspruch 6, **dadurch gekennzeichnet, daß** die Steuervorrichtung die erste Potential-Anlegevorrichtung auf einen Nicht-Ladezustand schaltet, so daß ein nicht-bildtragender Abschnitt des Bildträgerteils nicht aufgeladen wird.

8. Gerät nach Anspruch 5, **dadurch gekennzeichnet, daß** die Potential-Erzeugungsvorrichtung auch zum Entfernen von elektrischer Ladung von dem nicht-bildtragenden Abschnitt des Bildträgerteils (1) dient.

9. Gerät nach Anspruch 8, **dadurch gekennzeichnet, daß** das Bildträgerteil (1) ein lichtempfindliches Teil aufweist und die Potential-Erzeugungsvorrichtung ein Teil (9) zum Projizieren von Licht auf das lichtempfindliche Teil aufweist.

10. Gerät nach den Ansprüchen 1 bis 9, **dadurch gekennzeichnet, daß** die Übertragungsvorrichtung (6) das Bildträgerteil (1) berühren kann.

11. Gerät nach den Ansprüchen 1 bis 10, **dadurch gekennzeichnet, daß** der Absolutwert des dritten Potentials geringer als der Absolutwert des zweiten Potentials ist.

12. Gerät nach den Ansprüchen 1 bis 11, **dadurch gekennzeichnet, daß** die Übertragungsvorrichtung (6) mit einem Druck von nicht mehr als 300 g/cm² an das Bildträgerteil (1) gedrückt wird.

13. Gerät nach den Ansprüchen 1 bis 12, **dadurch gekennzeichnet, daß** die Bildübertragungsvorrichtung eine Härte von nicht mehr als 30 Grad (Japanische Industrienorm A, "Japanese Industrial Standard A") aufweist.

## Revendications

1. Appareil de formation d'image comprenant: un élément mobile (1) de support d'image; un moyen (2, 14) d'application d'un premier potentiel pour charger électriquement ledit élément de support d'image à un premier potentiel; un moyen (3) de formation d'image latente pour former une image latente sur l'élément de support d'image; un moyen (4) de formation d'image de toner pour former une image de toner sur ledit élément de support d'image par développement de l'image latente avec du toner qui est chargé électriquement; un moyen de transport pour délivrer un matériau d'enregistrement (10) dans une position de transfert d'image; et un moyen (6) de transfert d'image pouvant être mis en contact avec l'arrière d'un matériau d'enregistrement dans ladite position de transfert pour transférer l'image de toner depuis ledit élément de support d'image sur le matériau d'enregistrement; un moyen (7) d'application d'un second potentiel pour appliquer un second potentiel audit moyen de transfert (6) lorsque le matériau d'enregistrement n'est pas dans la position de transfert d'image; et un moyen de commande (13) capable de commander les moyens d'application des premier et second potentiels;
caractérisé en ce qu'un moyen (2, 11, 13; 9, 13; ou 3, 13) de fourniture de potentiel est inclus pour appliquer un troisième potentiel sur une partie de l'élément de support d'image à opposer au moyen (6) de transfert d'image au cours de son action de non-transfert, et en ce que ledit moyen de commande (13) sert à faire fonctionner lesdits moyens d'application des premier et second potentiels et ledit moyen de fourniture de potentiel de telle sorte que ledit moyen d'application du second potentiel applique ledit second potentiel audit moyen de transfert (6) lorsque le matériau d'enregistrement n'est pas dans la position de transfert, ledit moyen (9, 13) de fourniture de potentiel fournissant ledit troisième potentiel sur la partie dudit élément (1) de support d'image qui doit être présentée dans la position de transfert au cours de l'application du second potentiel par ledit second moyen d'application, le troisième potentiel étant à un niveau de tension différent de celui du premier potentiel dans un sens opposé à celui de la polarité de la charge électrique du toner, à la suite de quoi un champ électrique pour transférer le toner depuis ledit moyen de transfert sur ledit moyen de support d'image, est formé par ledit second potentiel et ledit troisième potentiel.

2. Appareil selon la revendication 1, caractérisé en ce que ledit moyen d'application du second potentiel fournit ledit second potentiel à une polarité qui est la même que celle de la charge du toner.

3. Appareil selon la revendication 1 ou 2, caractérisé en ce que ledit moyen d'application du premier potentiel fournit le premier potentiel à une polarité qui est la même que celle de la charge du toner.

4. Appareil selon la revendication 1 ou 2, caractérisé en ce que ledit moyen de fourniture de potentiel fournit ledit troisième potentiel dont la valeur absolue est inférieure à la valeur absolue dudit second potentiel.

5. Appareil selon la revendication 1 ou 2, caractérisé en ce que le moyen de fourniture de potentiel fournit ledit troisième potentiel à une polarité qui est la même que celle du premier potentiel et avec une valeur absolue supérieure à celle du premier potentiel.

6. Appareil selon l'une quelconque des revendications 1 à 5, caractérisé en ce que ledit moyen (2, 11, 13; 14, 11, 13) d'application du premier potentiel fonctionne aussi comme ledit moyen de fourniture de potentiel.

7. Appareil selon la revendication 6, caractérisé en ce que ledit moyen de commande est agencé pour commuter ledit moyen d'application du premier potentiel dans un état de non-chargement de telle sorte qu'une partie non porteuse d'image dudit élément de support d'image n'est pas chargée.

8. Appareil selon la revendication 5, caractérisé en ce que ledit moyen de fourniture de potentiel fonctionne aussi pour supprimer la charge électrique de ladite partie non porteuse d'image dudit élément (1) de support d'image.

9. Appareil selon la revendication 8, caractérisé en ce que ledit élément (1) de support d'image comporte un élément photosensible, et le moyen de fourniture de potentiel comporte un moyen (9) pour projeter de la lumière sur ledit élément photosensible.

10. Appareil selon les revendications 1 à 9, caractérisé en ce que ledit moyen de transfert (6) peut être mis en contact avec ledit élément (1) de support d'image.

11. Appareil selon les revendications 1 à 10, caractérisé en ce que la valeur absolue dudit troisième potentiel est inférieure à la valeur absolue dudit second potentiel.

12. Appareil selon les revendications 1 à 11, caractérisé en ce que ledit moyen de transfert (6) est en contact par pression avec ledit élément (1) de support d'image avec une pression non supérieure à 300 g/cm².

13. Appareil selon les revendications 1 à 12, dans lequel ledit moyen de transfert d'image a une dureté non supérieure à 30 degrés (standard industriel japonais A).
